# EUROPEAN PATENT APPLICATION

(11) **EP 2 017 304 A1**
(43) Date of publication of application: **21.01.2009**
(21) Application number: 07713842.8
(22) Date of filing: 06.02.2007
(51) Int. Cl.: C08L 65/00, B32B 15/08, C08J 5/24

(54) **PROCESS FOR PRODUCING CROSSLINKABLE RESIN MOLDING**

(30) Priority: 06.02.2006 JP 2006028591; 06.02.2006 JP 2006028601; 30.10.2006 JP 2006293847
(71) Applicant: Zeon Corporation, Tokyo 100-8246 (JP)
(72) Inventor: OHTAKI, Tomoyoshi, Chiyoda-ku, Tokyo 1008246 (JP); ONISHI, Kazuyuki, Chiyoda-ku, Tokyo 1008246 (JP); SUZUKI, Narumi, Chiyoda-ku, Tokyo 1008246 (JP); KOJIMA, Kiyoshige, Chiyoda-ku, Tokyo 1008246 (JP); KODEMURA, Junji, Chiyoda-ku, Tokyo 1008246 (JP)
(74) Representative: Vossius & Partner
(86) International application number: PCT/JP2007/052013
(87) International publication number: WO 2007/091551

(57) **Abstract**

A process for producing a crosslinkable resin formed product is disclosed which comprises providing a polymerizable composition containing a cycloolefin monomer, a metathesis polymerization catalyst, a chain transfer agent, and a crosslinking agent, and heating the polymerizable composition to 50°C or more to effect ring-opening metathesis bulk polymerization, the temperature of the polymerizable composition before heating being maintained at -10°C to +20°C. According to the present invention, a process for efficiently producing a crosslinkable resin formed product which exhibits excellent flowability when melted by heat and does not produce voids(blurs) inside a laminate or impair flatness when laminated on a substrate is provided.

## Description

### TECHNICAL FIELD

The present invention relates to a process for efficiently producing a crosslinkable resin formed product exhibiting excellent flowability when melted by heat.

### BACKGROUND ART

Cycloolefin resins obtained by polymerizing cycloolefin monomers have excellent mechanical properties, impact resistance, weather resistance, insulating properties, and the like, and have been utilized as formed products in a wide variety of fields. In recent years, cycloolefin resins have attracted attention as a material for forming insulating layers of wiring boards for which high electrical conductive reliability and excellent high-frequency characteristics are demanded.

For example, Patent Document 1 discloses a crosslinked formed product obtained by forming a norbornene resin composition prepared by uniformly dispersing a thermoplastic hydrogenated ring-opened norbornene resin, an organic peroxide, and a crosslinking co-agent in a specific ratio into a film or a prepreg, laminating the film or the prepreg on a substrate, and causing the composition to be crosslinked and melted by heat-pressure forming.

The method disclosed in Patent Document 1, however, requires applying the thermoplastic norbornene resin composition solution to a substrate to obtain a sheet, separating the sheet from the substrate, layering the sheet on a copper foil or the like, and heat-pressing the layers. Specifically, since this method is complicated due to many steps, this method is not necessarily advantageous when manufacturing crosslinked formed products on an industrial scale. Moreover, the product manufactured by this method may undergo problems such as copper foil peeling due to the remaining solvent or blistering due to gas generation.

In order to solve these problems, Patent Document 2 proposes a method of manufacturing a post-crosslinkable thermoplastic resin by bulk polymerization of a polymerizable composition (A) containing a norbornene monomer, a metathesis polymerization catalyst, a chain transfer agent, and a crosslinking agent, and a method of crosslinking the thermoplastic resin after laminating the thermoplastic resin on a metal foil or the like, as required. A post-crosslinkable thermoplastic resin which is free from problems such as copper foil peeling due to the remaining solvent or blistering due to gas generation can be efficiently produced by a simple process using the proposed method.

Patent Document 3 describes a cycloolefin resin film with excellent adhesiveness which can be efficiently produced by preparing a polymerizable composition by mixing a cycloolefin monomer with a metathesis polymerization catalyst, immediately applying the polymerizable composition to a supporting body or impregnating the supporting body with the polymerizable composition, and heating the supporting body to a specific temperature so that the polymerizable composition undergoes bulk polymerization.

However, when the cycloolefin resin film described in Patent Document 2 or 3 is laminated on a substrate with a circuit pattern formed on its surface to produce a wiring board, the adhesion of the cycloolefin resin film to the substrate may be insufficient, producing voids(blurs) inside the laminate or impairing flatness.

[Patent Document 1] JP-A-6-248164
[Patent Document 2] JP-A-2004-244609 (WO 2004/003052)
[Patent Document 3] WO 2004/069895

### DISCLOSURE OF THE INVENTION

### Problems to be Solved by the Invention

The present invention has been achieved in view of this situation and has an object of providing a process for efficiently producing a crosslinkable resin formed product which exhibits excellent flowability when melted by heat, and does not produce voids (blurs) inside the laminate or impair flatness when laminated on a substrate. Means for Solving the Problem

In order to achieve the above object, the inventors of the present invention have conducted intensive studies on a cycloolefin resin obtained by ring-opening metathesis bulk polymerization of cycloolefin monomers and a crosslinkable resin formed product containing a crosslinking agent. As a result, the inventors have found that, as opposed to a resin obtained by a conventional method having a wide molecular weight distribution and low flowability when heated to a molten state, which results in poor adhesion to a substrate and insufficient pattern embedding, the cycloolefin resin contained in the resulting formed product exhibits excellent flowability when melted by heat, and does not produce voids inside the laminate or impair flatness when laminated on a substrate, if the cycloolefin resin has a narrow molecular weight distribution (Mw/Mn).

The inventors have conducted further studies on a process for efficiently producing a crosslinkable resin formed product having such properties, and have found that such a crosslinkable resin formed product can be efficiently produced by maintaining the temperature of a polymerizable composition comprising a cycloolefin monomer, a metathesis polymerization catalyst, a chain transfer agent, and a crosslinking agent before heating for bulk polymerization at -10°C to +20°C. This finding has led to the completion of the present invention.

Specifically, the present invention provides processes for producing a crosslinkable resin formed product described in (1) to (10) below.
(1) A process for producing a crosslinkable resin formed product comprising providing a polymerizable composition containing a cycloolefin monomer, a metathesis polymerization catalyst, a chain transfer agent, and a crosslinking agent, and heating the polymerizable composition to 50°C or more to effect ring-opening metathesis bulk polymerization, the temperature of the polymerizable composition before heating being maintained at -10°C to +20°C.
(2) The process according to (1), wherein the polymerizable composition is heated to 80 to 200°C when polymerized by ring-opening metathesis bulk polymerization.
(3) The process according to (1) or (2), wherein the heating is carried out using a heating roller, a heating plate, or a heating furnace.

(4) The process according to (1) or (2), wherein the heating is carried out using a hot blast heater in which the difference between the maximum temperature and the minimum temperature is not more than 10°C.
(5) A process for producing a crosslinkable resin formed product comprising a step (I) of preparing a polymerizable composition by mixing a cycloolefin monomer, a metathesis polymerization catalyst, a chain transfer agent, and a crosslinking agent, a step (II) of coating or impregnating a supporting body with the polymerizable composition, and a step (III) of effecting ring-opening metathesis bulk polymerization by heating the polymerizable composition to 50°C or more, the polymerizable composition before heating being maintained at -10°C to +20°C.
(6) The process according to (5), wherein the supporting body is a long supporting body, and the steps (I) to (III) are continuously carried out while conveying the supporting body in a specific direction.

(7) The process according to (5) or (6), wherein the supporting body is a resin film, a fiber material, or a metal foil.
(8) The process according to any one of (5) to (7), wherein the step (III) is carried out using a hot blast heater in which the difference between the maximum temperature and the minimum temperature is not more than 10°C.
(9) The process according to any one of (1) to (8), wherein the cycloolefin monomer has an aromatic ring.
(10) The process according to any one of (1) to (9), wherein the metathesis polymerization catalyst is a ruthenium complex catalyst having a hetero atom-containing carbene compound as a ligand.

### Effect of the Invention

According to the present invention, a process for efficiently producing a crosslinkable resin formed product which exhibits excellent flowability when melted by heat and does not produce voids (blurs) inside the laminate or impair flatness when laminated with a substrate is provided.

### BRIEF DESCRIPTION OF THE DRAWINGS

FIG. 1 is a diagram showing an outline of a continuous forming apparatus used for forming a laminate of the sheet-like crosslinkable resin formed product (crosslinkable resin sheet) and a supporting film used in Examples 1 to 6.
FIG. 2, which does not directly explain the present invention, is a top plan view of an IPC multipurpose substrate used in Examples.
FIG. 3, which also does not directly explain the present invention, is a diagram showing a method of evaluating flatness and embedding properties using an IPC substrate.

### EXPLANATION OF SYMBOLS

11: Monomer liquid composition tank
12: Catalyst solution tank
3 and 4: Small tube pump
15: Static mixer
16a and 16b: Coating section
17: Supporting body delivery section
18: Supporting body (glass cloth)
19a and 19b: Protective film delivery section
20: Protective film (polyethylene naphthalate film)
21 a and 21b: Metal roll
22: Air curtain
23: Hot blast heater (floating dryer)
24: Crosslinkable resin sheet (resin sheet)
25: Film roll-up section

### BEST MODE FOR CARRYING OUT THE INVENTION

The present invention is described below in detail.
The process for producing a crosslinkable resin formed product of the present invention comprises providing a polymerizable composition containing (1) a cycloolefin monomer, (2) a metathesis polymerization catalyst, (3) a chain transfer agent, and (4) a crosslinking agent (hereinafter referred to as "polymerizable composition (A)"), and heating the polymerizable composition to 50°C or more to effect ring-opening metathesis bulk polymerization, wherein the temperature of the polymerizable composition (A) before heating is maintained at -10°C to +20°C.

### (1) Cycloolefin monomer

The cycloolefin monomer used in the present invention is a compound having a cyclic structure and a ring-opening polymerizable carbon-carbon double bond. As examples of the cyclic structure, an aromatic ring structure, a cycloalkane structure, a cycloalkene structure, and the like can be given.

Specific examples of the cycloolefin monomer used in the present invention include a monocyclic olefin monomer, a norbornene monomer, and the like.

These cycloolefin monomers may be substituted with a hydrocarbon group such as an alkyl group, an alkenyl group, an alkylidene group, or an aryl group, or a polar group such as a carboxyl group, an alkoxycarbonyl group, a hydroxyl group, or an alkoxy group.

As examples of the monocyclic olefin monomer, a cyclic monoolefin or cyclic diolefin having usually 4 to 20, and preferably 4 to 10 carbon atoms can be given.

Specific examples of the cyclic monoolefin include cyclobutene, cyclopentene, methylcyclopentene, cyclohexene, methylcyclohexene, cycloheptene, and cyclooctene. Specific examples of the cyclic diolefin include cyclohexadiene, methylcyclohexadiene, cyclooctadiene, methylcyclooctadiene, and phenylcyclooctadiene.

The norbornene monomer is a monomer having a norbornene ring structure in the molecule. Examples of the norbornene monomer include (a) a norbornene monomer having no unsaturated bond except for a carbon-carbon unsaturated bond which participates in a polymerization reaction, such as norbornene, tetracyclododecene, alkyl-substituted norbornene, and alkyl-substituted tetracyclododecene, (b) a norbornene monomer having an unsaturated bond other than a carbon-carbon unsaturated bond which participates in the polymerization reaction, such as ethylidenenorbornene, vinylnorbornene, ethylidenetetracyclododecene, and dicyclopentadiene, (c) a norbornene monomer having a polar group such as methoxycarbonylnorbornene and methoxycarbonyltetracyclododecene, (d) a norbornene monomer having an aromatic ring, and the like.

These cycloolefin monomers may be used either individually or in combination of two or more.
If two or more monomers are used, the glass transition temperature and the melt temperature of the resulting resin may be controlled by changing the mixing ratio.

In the present invention, the norbornene monomers are preferable because a cycloolefin resin having excellent mechanical properties, impact resistance, weather resistance, insulating properties, and the like can be obtained, as mentioned later, by using the norbornene monomers.

Among the norbornene resins, the norbornene monomer (d) having an aromatic ring is preferable because of its narrow molecular weight distribution which allows the cycloolefin resin to have excellent flowability when melted by heat. A norbornene monomer having a condensed ring of an aliphatic ring having one or more carbon-carbon double bonds in the molecule (hereinafter referred to as "unsaturated aliphatic ring") and a ring having aromaticity (hereinafter referred to as "aromatic ring") is particularly preferable. The norbornene monomer having such a condensed ring is hereinafter referred to as "aromatic condensed ring-containing cycloolefin".

The term "condensed ring" refers to a ring in which an unsaturated aliphatic ring and an aromatic ring are ortho-fused or ortho- and peri-fused. These rings share two atoms and one bond.

As examples of the unsaturated aliphatic ring, a monocyclic ring and a polycyclic ring such as a bicyclic ring, a tricyclic ring, and a tetra- or higher cyclic ring can be given.
The aromatic ring may be a condensed carbon ring or a condensed hetero ring which may be a monocyclic ring or a polycyclic ring. Examples of the aromatic ring include a benzene ring; a condensed carbon ring such as a naphthalene ring, an anthracene ring, and a phenanthrene ring; and a condensed hetero ring such as a pyridine ring, a pyrimidine ring, a furan ring, a thiophene ring, an imidazole ring, a pyrrole ring, an oxazole ring, a pyrazine ring, and a benzimidazole ring.

Among these, aromatic hydrocarbon rings such as a benzene ring, a naphthalene ring, and a furan ring are preferable because these rings do not inhibit a metathesis polymerization reaction.

As examples of the aromatic condensed ring-containing cycloolefin having a monocyclic unsaturated aliphatic ring, bicyclo[4.2.0]octa-1,3,5,7-tetraene, bicyclo[4.4.0]deca-1,3,5,8-tetraene, bicyclo[6.4.0]dodeca-1(8),4,9,11-tetraene, and the like can be given.

As examples of the aromatic condensed ring-containing cycloolefin having a bicyclic unsaturated aliphatic ring, tricyclo[6.2.1.0^{2,7}]undeca-2,4,6,9-tetraene, tetracyclo[6.6.2.0^{2,7}.0^{9,14}]hexadeca-2,4,6,9(10),11,13,15-heptaene, tetracyclo[10.2.1.0^{2,11}.0^{4,9}]pentadeca-2,4,6,8,10,13-hexaene, and the like can be given.

As examples of the aromatic condensed ring-containing cycloolefin having a tricyclic unsaturated aliphatic ring, tetracyclo[9.2.1.0^{2,10}.0^{3,8}]tetradeca-3,5,7,12-tetraene (also called 1,4-methano-1,4,4a,9a-tetrahydro-9H-fluorene), tetracyclo[10.2.1.0^{2,11}.0^{4,9}]pentadeca-4,6,8,13-tetraene (also called 1,4-methano-1,4,4a,9,9a,10-hexahydroanthracene), tetracyclo[10.2.1.0^{2,11}.0^{3,8}]pentadeca-3,5,7,13-tetraene, a cyclopentadiene-acenaphthylene adduct, pentacyclo[13.2.1.0^{2,14}.0^{3,12}.0^{5,10}]octadeca-3,5,7,9,11,16-hexaene, pentacyclo[13.2.1.0^{2,14}.0^{3,12}.0^{4,9}]octadeca-3,5,7,9,11,16-hexaene, pentacyclo[13.2.1.0^{2,14}.0^{3,12}.0^{6,11}]octadeca-3,5,7,9,11,16-hexaene, and the like can be given.

As examples of the aromatic condensed ring-containing cycloolefin having a tetra- or higher cyclic unsaturated aliphatic ring, hexacyclo[13.2.1.1^{3,13}.0^{2,14}.0^{4,12}.0^{5,10}]nonadeca-5,7,9,16-tetraene; octacyclo[17.2.1.1^{3,17}.1^{5,15}.0^{2,18}.0^{4,16}.0^{5,14}.0^{7,12}]tetraeicosa-7,9,11,20-tetraene, and the like can be given.

### (2) Metathesis polymerization catalyst

There are no specific limitations to the metathesis polymerization catalyst used in the present invention inasmuch as the catalyst can accelerate the metathesis ring-opening polymerization. For example, ring-opening metathesis reaction catalysts described in Olefm Metathesis and Metathesis Polymerization (K.J. Ivin and J.C. Mol, Academic Press, San Diego, 1997) may be used.

As the metathesis polymerization catalyst that can be used, a complex formed from a plurality of ions, atoms, polyatomic ions, and/or compounds bonded to a transition metal atom as the center atom is preferable. As the transition metal atom, the atoms of the groups V, VI, and VIII (in a long-period form of the Periodic Table, hereinafter the same) are used. Examples of the atoms belonging to each group include tantalum as the group V atom, molybdenum and tungsten as the group VI atom, and ruthenium and osmium as the group VIII atom.

Among these, a complex of ruthenium or osmium (group VIII) is preferably used as the metathesis polymerization catalyst, with a ruthenium-carbene complex being particularly preferable. The ruthenium-carbene complex exhibits high resin film productivity due to excellent catalytic activity during bulk polymerization. In addition, since the catalyst is comparatively stable and is not easily deactivated in oxygen or moisture in the air, the resin can be produced under atmospheric conditions using the catalyst.
The ruthenium-carbene complex is a compound shown by the following formulas (1) and (2).

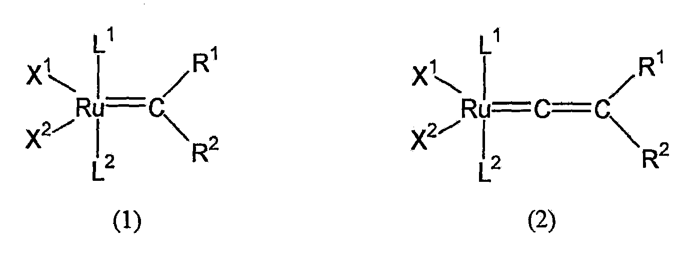

wherein R¹ and R² individually represent a hydrogen atom, a halogen atom, or a hydrocarbon group having 1 to 20 carbon atoms which may contain a halogen atom, an oxygen atom, a nitrogen atom, a sulfur atom, a phosphorus atom, or a silicon atom, preferably at least one of R¹ and R² being a hetero atom-containing carbene compound, X¹ and X² individually represent an anionic ligand, and L¹ and L² individually represent a hetero atom-containing carbene compound or a neutral electron-donor compound. R¹, R², X¹, X², L¹, and L² may bond in any optional combination to form a multidentate chelated ligand.

The anionic ligands X¹ and X² have a negative charge when separated from the center metal. Examples of the ligand include halogen atoms such as a fluorine atom, a chlorine atom, a bromine atom, or an iodine atom, a diketonate group, a substituted cyclopentadienyl group, an alkoxy group, an aryloxy group, a carboxyl group, and the like. Of these, a halogen atom is preferable, and a chlorine atom is more preferable.

Specific examples of the hetero atom include N, O, P, S, As, and Se. Of these, N, O, P, S, and the like are preferable, and N is particularly preferable, because a stable carbene compound can be obtained.

A hetero atom-containing carbene compound having hetero atoms bonded to both sides of the carbene carbon atom is preferable, and a carbene compound having a hetero ring which includes a carbene carbon atom and hetero atoms on both sides of the carbon atom is more preferable. It is desirable that hetero atoms adjacent to the carbene carbon atom have a bulky substituent.

As examples of such hetero atom-containing carbene compounds, compounds shown by the following formulas (3) and (4) can be given,

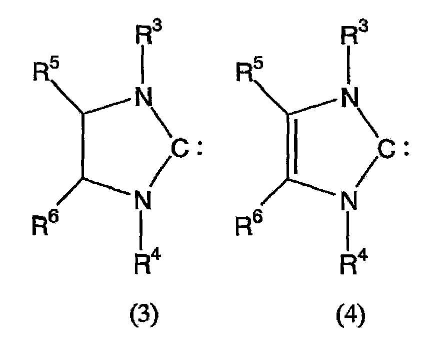

wherein R³ to R⁶ individually represent a hydrogen atom, a halogen atom, or a hydrocarbon group having 1 to 20 carbon atoms which may contain a halogen atom, an oxygen atom, a nitrogen atom, a sulfur atom, a phosphorus atom, or a silicon atom. R³ to R⁶ may be bonded in any optional combination to form a ring.
Specific examples of the compound shown by the formula (3) or (4) include 1,3-dimesitylimidazolydin-2-ylidene, 1,3-di(1-adamantyl)imidazolydin-2-ylidene, 1-cyclohexyl-3-mesitylimidazolydin-2-ylidene, 1,3-dimesityloctahydrobenzimidazol-2-ylidene, 1,3-diisopropyl-4-imidazolin-2-ylidene, 1,3-di(1-phenylethyl)-4-imidazolin-2-ylidene, and 1,3-dimesityl-2,3-dihydrobenzimidazol-2-ylidene.

In addition to the compounds shown by the above formula (3) or (4), other hetero atom-containing carbene compounds such as 1,3,4-triphenyl-2,3,4,5-tetrahydro-1H-1,2,4-triazol-5-ylidene, 1,3-dicyclohexylhexahydropyrimidin-2-ylidene, N,N,N',N'-tetraisopropylformamidinylidene, 1,3,4-triphenyl-4,5-dihydro-1H-1,2,4-triazol-5-ylidene, and 3-(2,6-diisopropylphenyl)-2,3-dihydrothiazol-2-ylidene may be used.

The neutral electron-donor compound may be any ligand having a neutral charge when separated from the center metal. Specific examples include carbonyls, amines, pyridines, ethers, nitriles, esters, phosphines, thioethers, aromatic compounds, olefins, isocyanides, and thiocyanates. Of these, phosphines, ethers, and pyridines are preferable, and a trialkylphosphine is more preferable.

Examples of the ruthenium complex shown by the formula (1) include ruthenium complex compounds in which a hetero atom-containing carbene compound and a neutral electron-donating compound are bonded such as benzylidene(1,3-dimesitylimidazolydin-2-ylidene)(tricyclohexylphosphine)ruthenium dichloride, (1,3-dimesitylimidazolydin-2-ylidene)(3-methyl-2-buten-1-ylidene) (tricyclopentylphosphine)ruthenium dichloride, benzylidene(1,3-dimesityl-octahydrobenzimidazol-2-ylidene)(tricyclohexylphosphine) ruthenium dichloride, benzylidene[1,3-di(1-phenylethyl)-4-imidazolin-2-ylidene](tricyclohexylphosphine) ruthenium dichloride, benzylidene(1,3-dimesityl-2,3-dihydrobenzimidazol-2-ylidene)(tricyclohexylphosphine) ruthenium dichloride, benzylidene(tricyclohexylphosphine) (1,3,4-triphenyl-2,3,4,5-tetrahydro-1H-1,2,4-triazol-5-ylidene)ruthenium dichloride, (1,3-diisopropylhexahydropyrimidin-2-ylidene)(ethoxymethylene) (tricyclohexylphosphine)ruthenium dichloride, benzylidene(1,3-dimesitylimidazolydin-2-ylidene)pyridine ruthenium dichloride, (1,3-dimesitylimidazolydin-2-ylidene)(2-phenylethylidene)(tricyclohexylphosphine) ruthenium dichloride, and (1,3-dimesityl-4-imidazolin-2-ylidene)(2-phenylethylidene)(tricyclohexylphosphine) ruthenium dichloride;

ruthenium compounds in which two neutral electron-donor compounds are bonded such as benzylidenebis(tricyclohexylphosphine)ruthenium dichloride and (3-methyl-2-buten-1-ylidene)bis(tricyclopentylphosphine)ruthenium dichloride; ruthenium complex compounds in which two hetero atom-containing carbene compounds are bonded such as benzylidenebis(1,3-dicyclohexylimidazolydin-2-ylidene)ruthenium dichloride and benzylidenebis(1,3-diisopropyl-4-imidazolin-2-ylidene)ruthenium dichloride; and the like.

Examples of the ruthenium complex shown by the formula (2) include (1,3-dimesitylimidazolydin-2-ylidene)(phenylvinylidene)(tricyclohexylphosphine) ruthenium dichloride, (t-butylvinylidene)(1,3-diisopropyl-4-imidazolin-2-ylidene)(tricyclopentylphosphine) ruthenium dichloride, and bis(1,3-dicyclohexyl-4-imidazolin-2-ylidene)phenylvinylidene ruthenium dichloride.

These ruthenium complex catalysts can be produced by the methods described in Org. Lett., 1999, Vol. 1, p. 953 and Tetrahedron. Lett., 1999, Vol. 40, p. 2247, for example.

The metathesis polymerization catalyst is used in such an amount that the molar ratio of the metal atoms in the catalyst to the cycloolefins is 1:2,000 to 1:2,000,000, preferably 1:5,000 to 1:1,000,000, and more preferably 1:10,000 to 1:500,000.

In the present invention, an activator (co-catalyst) may be used in combination with the metathesis polymerization catalyst to control the polymerization activity or to increase the polymerization reaction ratio.

As examples of the activator, an alkyl compound, a halide, an alkoxy compound, an aryloxy compound, and the like of aluminum, scandium, tin, titanium, or zirconium can be given.

Specific examples of the activator include trialkoxyaluminum, triphenoxyaluminum, dialkoxyalkylaluminum, alkoxydialkylaluminum, trialkylaluminum, dialkoxyaluminum chloride, alkoxyalkylaluminum chloride, dialkylaluminum chloride, trialkoxyscandium, tetraalkoxytitanium, tetraalkoxytin, and tetraalkoxyzirconium.

The activator is used in such an amount that the molar ratio of the metal atoms in the metathesis polymerization catalyst to the activator is 1:0.05 to 1:100, preferably 1:0.2 to 1:20, and more preferably 1:0.5 to 1:10.

### (3) Chain transfer agent

In the present invention, a chain transfer agent is used as the component of the polymerizable composition (A). The molecular weight of the cycloolefin resin can be adjusted using the chain transfer agent.

As examples of the chain transfer agent, a linear olefin which may have a substituent can be given. Specific examples of the chain transfer agent include aliphatic olefins such as 1-hexene and 2-hexene; aromatic olefins such as styrene, divinylbenzene, and stilbene; alicyclic olefins such as vinylcyclohexane; vinyl ethers such as ethyl vinyl ether; vinyl ketones such as methyl vinyl ketone, 1,5-hexadien-3-one, 2-methyl-1,5-hexadien-3-one; and compounds shown by the formula (α) CH₂=CH-Q (wherein Q is a group which has at least one group selected from the group consisting of a methacryloyl group, an acryloyl group, a vinylsilyl group, an epoxy group, and an amino group). These chain transfer agents may be used either individually or in combination of two or more.

Of these, the compounds shown by the formula (α) CH₂=CH-Q are preferable, because the group Q is introduced into the polymer terminal and contributes to the crosslinking of the polymer, thereby increasing the crosslinking density.

As specific examples of the compound shown by the formula (α) CH₂=CH-Q, compounds in which Q is a group having a methacryloyl group, such as vinyl methacrylate, allyl methacrylate, 3-buten-1-yl methacrylate, 3-buten-2-yl methacrylate, styryl methacrylate, pentenyl methacrylate, hexenyl methacrylate, heptenyl methacrylate, octenyl methacrylate, nonenyl methacrylate, decenyl methacrylate, and undecenyl methacrylate; compounds in which Q is a group having an acryloyl group such as allyl acrylate, 3-buten-1-yl acrylate, 3-buten-2-yl acrylate, 1-methyl-3-buten-2-yl acrylate, styryl acrylate, pentenyl acrylate, hexenyl acrylate, heptenyl acrylate, octenyl aclylate, nonenyl acrylate, decenyl acrylate, undecenyl acrylate, and ethylene glycol diacrylate;

compounds in which Q is a group having a vinylsilyl group, such as allyltrivinylsilane, allylmethyldivinylsilane, and allyldimethylvinylsilane; compounds in which Q is a group having an epoxy group, such as glycidyl acrylate and allyl glycidyl ether; compounds in which Q is a group having an amino group such as allylamine, 2-(diethylamino)ethanol vinyl ether, 2-(diethylamino)ethyl acrylate, and 4-vinylaniline; and the like can be given.

Among these, compounds shown by the formula (β) CH₂=CH-Y-OCO-CR⁷=CH₂ are more preferable. In the formula (β), R⁷ represents a hydrogen atom or a methyl group, and Y represents a divalent hydrocarbon group having 3 to 20 carbon atoms.

As examples of the divalent hydrocarbon group having 3 to 20 carbon atoms represented by Y, an alkylene group and a phenylene group can be given. Among these groups, an alkylene group is preferable due to its excellent metathesis reactivity. An alkylene group having 4 to 15 carbon atoms is more preferable, with an alkylene group having 4 to 11 carbon atoms being particularly preferable.

Preferable examples of the compound shown by the formula (β) include pentenyl methacrylate, hexenyl methacrylate, heptenyl methacrylate, octenyl methacrylate, nonenyl methacrylate, decenyl methacrylate, undecenyl methacrylate, pentenyl acrylate, hexenyl acrylate, heptenyl acrylate, octenyl acrylate, nonenyl acrylate, decenyl acrylate, undecenyl acrylate, and the like.

If the compound shown by the formula (β) is used as the chain transfer agent, a crosslinkable resin with a narrow molecular distribution can be easily obtained because the compound shown by the formula (β) has high metathesis polymerization reactivity. Accordingly, the crosslinkable resin flows evenly when heated on a substrate and nicely embedded in the surface of the substrate.

The amount of the chain transfer agent to be added is usually 0.01 to 10 parts by weight, and preferably 0.1 to 5 parts by weight for 100 parts by weight of the cycloolefin monomer. The amount of the chain transfer agent in this range contributes to a high polymerization reaction ratio and efficient production of a post-crosslinkable thermoplastic resin.

### (4) Crosslinking agent

As examples of the crosslinking agent that can be used in the present invention, a radical generating agent, an epoxy compound, an isocyanate group-containing compound, a carboxyl group-containing compound, an acid anhydride group-containing compound, an amino-group containing compound, a Lewis acid, and the like can be given. These crosslinking agents may be used either individually or in combination of two or more. Among these, a radical generating agent or an epoxy compound is preferable.

As examples of the radical generating agent, organic peroxides and diazo compounds can be given.
Examples of the organic peroxides include ketone peroxides such as methyl ethyl ketone peroxide, methyl isobutyl ketone peroxide, cyclohexanone peroxide, and methyl cyclohexanone peroxide; acyl peroxides such as propionyl peroxide, 3,5,5-trimethylhexanoyldecanoyl peroxide, lauroyl peroxide, and benzoyl peroxide; hydroperoxides such as tert-butyl hydroperoxide, cumene hydroperoxide, diisopropylbenzene hydroperoxide, and p-menthane hydroperoxide; dialkyl peroxides such as di-tert-butyl peroxide, tert-butylcumyl peroxide, and dicumyl peroxide; peroxy ketals such as 1,4-bis(t-butylperoxydiisopropyl)benzene, 1,1-bis(t-butylperoxy)-3,5,5-trimethylcyclohexane, and n-butyl-4,4'-bis(tert-butylperoxy)butane; alkyl peresters such as tert-butyl peroxyacetate, tert-butyl peroxyisobutyrate, tert-butyl peroxyoctoate, and 2,5-dimethyl-2,5-dibenzoyl peroxyhexane; peroxycarbonates such as di-2-ethylhexyl peroxydicarbonate and diisopropyl peroxydicarbonate; water-soluble peroxides such as succinic acid peroxide; alkylsilyl peroxides such as t-butyltrimethylsilyl peroxide; and the like.

Examples of the diazo compound include 4,4'-bisazidobenzal(4-methyl)cyclohexanone, 4,4'-diazidochalcone, 2,6-bis(4'-azidobenzal)cyclohexanone, 2,6-bis(4'-azidobenzal)-4-methylcyclohexanone, 4,4'-diazidodiphenylsulfone, 4,4'-diazidodiphenylmethane, 2,2'-diazidostilbene, and the like. Of these, dialkyl peroxides are preferable due to small inhibition to the metathesis polymerization reaction.

As examples of the epoxy compound, compounds having two or more epoxy groups in the molecule, a phenol novolak epoxy compound, a cresol novolak epoxy compound, and a cresol epoxy compound; glycidyl ether-type epoxy compounds such as a bisphenol A epoxy compound, a bisphenol F epoxy compound, a brominated bisphenol A epoxy compound, a brominated bisphenol F epoxy compound, and a hydrogenated bisphenol A epoxy compound; polyvalent epoxy compounds such as an alicyclic epoxy compound, a glycidyl ester epoxy compound, a glycidyl amine epoxy compound, and an isocyanurate epoxy compound; and the like can be given.

As examples of the isocyanate group-containing compound, compounds having two or more isocyanate groups in the molecule such as p-phenylene diisocyanate can be given.

As examples of the carboxyl group-containing compound, compounds having two or more carboxyl groups in the molecule such as fumaric acid can be given.

As examples of the acid anhydride group-containing compound, phthalic anhydride, pyromellitic anhydride, and the like can be given.

As examples of the amino group-containing compound, compounds having two or more amino groups in the molecule such as aliphatic diamines, aliphatic polyamines, aromatic diamines, and the like can be given.

As examples of the Lewis acid, silicon tetrachloride, hydrochloric acid, sulfuric acid, ferric chloride, aluminum chloride, stannic chloride, titanium tetrachloride, and the like can be given.

In the present invention, appropriate crosslinking agents may be selected according to the crosslinking site of the cycloolefin resin (described later). For example, when the polymer molecules are crosslinked at the carbon-carbon double bond, the radical generating agent may be used. When the crosslinkable resin having a carboxyl group or an acid anhydride group is crosslinked, the epoxy compound may be used. When the crosslinkable resin having a hydroxyl group is crosslinked, the isocyanate group containing compound may be used. When the crosslinkable resin having an epoxy group is crosslinked, the carboxyl group-containing compound and an acid anhydride group-containing compound may be used. In addition, the Lewis acid may also be used as a crosslinking agent for cationically crosslinking the molecules.

There are no specific limitations to the amount of the crosslinking agent. The amount can be appropriately determined according to the type of the crosslinking agent used. When the radical generating agent is used as the crosslinking agent, the amount of the crosslinking agent used is usually 0.1 to 10 parts by weight, and preferably 0.5 to 5 parts by weight for 100 parts by weight of the cycloolefin monomer. When the epoxy compound is used as the crosslinking agent, the amount of the crosslinking agent used is usually 1 to 100 parts by weight, and preferably 5 to 50 parts by weight for 100 parts by weight of the cycloolefin monomer.

In the present invention, a crosslinking co-agent may be used in combination with the crosslinking agent to improve the crosslinking effect. As examples of the crosslinking co-agent, known crosslinking co-agents, for example, dioxime compounds such as p-quinonedioxime, methacrylate compounds such as lauryl methacrylate, compounds having two or more allyl groups such as diallyl fumarate, diallyl phthalate, and triallyl cyanulate, imide compounds such as maleimide, and the like can be given.

Although there are no specific limitations to the amount of the crosslinking co-agent, the amount of the crosslinking co-agent used is usually 0 to 100 parts by weight, and preferably 0 to 50 parts by weight for 100 parts by weight of the cycloolefin monomer.

### (5) Radical crosslinking retarder

When a radical generating agent is used as a crosslinking agent in the present invention, it is preferable to add a radical crosslinking retarder to the polymerizable composition (A). The radical crosslinking retarder is a compound generally having a radical capture function, and exhibits an effect of delaying the radical crosslinking reaction caused by the radical generating agent. The flowability of the thermoplastic resin when laminating the resin and the storage stability of the thermoplastic resin can be improved by adding the radical crosslinking retarder to the polymerizable composition (A).

As examples of the radical crosslinking retarder, alkoxyphenols such as 4-methoxyphenol, 4-ethoxyphenol, 4-methoxy-2-t-butylphenol, 4-methoxy-3-t-butylphenol, and 4-methoxy-2,6-di-t-butylphenol; hydroquinones such as hydroquinone, 2-methylhydroquinone, 2,5-dimethylhydroquinone, 2-t-butylhydroquinone, 2,5-di-t-butylhydroquinone, 2,5-di-t-amylhydroquinone, 2,5-bis(1,1-dimethylbutyl)hydroquinone, and 2,5-bis(1,1,3,3-tetramethylbutyl)hydroquinone; catechols such as catechol, 4-t-butylcatechol, and 3,5-di-t-butylcatechol; and benzoquinones such as benzoquinone, naphthoquinone, and methylbenzoquinone; and the like can be given. Of these, alkoxyphenols, catechols, and benzoquinones are preferable, and alkoxyphenols are particularly preferable.

The amount of the radical crosslinking retarder is usually 0.001 to 1 mol, and preferably 0.01 to 1 mol for 1 mol of the radical generating agent.

Other additives such as a reinforcing agent, a modifier, an antioxidant, a flame retarder, a filler, a coloring agent, a light stabilizer, and the like may be optionally contained in the polymerizable composition (A).

As examples of the reinforcing agent, a glass fiber, a glass cloth, a paper substrate, a nonwoven glass fabric, and the like can be given. These additives may be used either individually or in combination of two or more.

The other additives may be added to the polymerizable composition (A) described later for improving film properties, providing the film with functions, improving workability of forming operation, and the like according to the application and purpose of use.
The amount of the other additives is usually 0.001 to 500 parts by weight for 100 parts by weight of the cycloolefin monomer.

The method for producing the polymerizable composition (A) is not particularly limited. For example, a method of separately preparing cycloolefin monomers (hereinafter referred to from time to time as "monomer liquid composition") and a catalyst solution in which a metathesis polymerization catalyst is dissolved or dispersed in a suitable solvent, and combining the monomer liquid composition and the catalyst solution immediately before reaction can be given. The chain transfer agent, the crosslinking agent, and the radical crosslinking retarder may be added either to the monomer liquid composition or the catalyst solution. Alternatively, these components may be added to a mixed composition obtained by mixing the monomer liquid composition and the catalyst solution.

The solvent in which the metathesis polymerization catalyst is dissolved or dispersed is not particularly limited insofar as the solvent is inert to the reaction.
For example, an aliphatic hydrocarbon solvent such as pentane, hexane, heptane, octane and decane; an alicyclic hydrocarbon solution such as cyclopentane, cyclohexane, methylcyclohexane, decahydronaphthalene, and bicycloheptane; an aromatic hydrocarbon solvent such as benzene, toluene, and xylene; a nitrogen-containing hydrocarbon solvent such as nitromethane, nitrobenzene, and acetonitrile; ethers such as diethyl ether and tetrahydrofuran; and a halogenated hydrocarbon solvent such as chloroform, carbon tetrachloride, 1,2-dichloroethane, chlorobenzene, and dichlorobenzene; and the like can be given. These solvents may be used either individually or in combination of two or more. In addition, a liquid antioxidant, a plasticizer, or an elastomer may be used as the solvent to an extent not reducing the activity of the metathesis polymerization catalyst.

The monomer liquid composition and the catalyst solution are usually mixed at -10°C to +40°C, preferably at -10°C to +20°C, and more preferably at 0°C to +10°C.

In order to contribute to a high production efficiency and consistent product quality, it is preferable in the present invention to continuously prepare the polymerizable composition (A) by continuously mixing the monomer liquid composition and the catalyst solution. In order to continuously prepare the polymerizable composition (A), the monomer liquid composition and the catalyst solution are respectively fed to a mixer using a metering pump.

There are no specific limitations to the metering pump insofar as the pump can measure the quantity of feed. A gear pump, a diaphragm pump, a tube pump, a rotary pump, an axial plunger pump, a cylinder pump, and the like can be given as examples.

There are no specific limitations to the mixer. For example, a static mixer, a dynamic mixer, an impingement mixer, and the like may be used. A common stirrer may also be used as the mixer. Of these, the impingement mixer is preferable due to its high productivity. Specifically, the monomer liquid composition is divided into two portions, which are caused to impinge upon each other, thereby generating impinging energy. The monomer liquid composition is mixed with the catalyst solution using the generated impinging energy. A system of mixing three or more portions (for example, two portions of the monomer liquid composition and one portion of the catalyst solution) is preferable.

In the bulk polymerization method, the above-mentioned polymerizable composition (A) is prepared and polymerized by heating the polymerizable composition (A) to a specific temperature.

In the present invention, the temperature of the polymerizable composition (A) before heating is adjusted to -10°C to +20°C. By adjusting the temperature of the polymerizable composition (A) in the range from -10°C to +20°C before heating, an increase in molecular weight at an early stage of polymerization can be suppressed so that a cycloolefin resin with a narrow molecular weight distribution can be efficiently produced.

There are no specific limitations to the method of controlling the temperature between -10°C and +20°C. A known cooling method such as a method of cooling the tank for storing the polymerizable composition (A) to a specific temperature, a method of cooling the pipe for feeding the prepared polymerizable composition (A), and the like can be given as examples.

The cycloolefin resin can be obtained by ring-opening metathesis bulk polymerization of the cycloolefin monomer by heating the polymerizable composition (A) to 50°C or more (peak temperature).

As the method for polymerizing the polymerizable composition (A) by ring-opening metathesis bulk polymerization, (a) a method of coating the polymerizable composition (A) or impregnating the polymerizable composition (A) on a supporting body and causing bulk polymerization, and (b) a method of causing bulk polymerization to occur in a mold can be given, for example.

A film-like crosslinkable resin formed product can be obtained if the method (a) is used.
As examples of the supporting body that can be used, a metal foil, a resin support film, a fiber material, a metal drum, a steel belt, a fluororesin belt, and the like can be given. Of these, a metal foil, a resin support film, and a fiber material are preferable.

As specific examples of the metal foil, a copper foil, an aluminum foil, a nickel foil, a chromium foil, a gold foil, a silver foil, and the like can be given. Of these, a copper foil is preferable. There are no specific limitations to the type of copper foil insofar as the copper foil can be used to form a copper clad laminate. The thickness and roughness of the copper foil can be appropriately selected according to the object of use.

The surface of the metal foil may be treated with a silane coupling agent, a thiol coupling agent, a titanate coupling agent, various adhesives, and the like.

As specific examples of the resin supporting film, a polyethylene terephthalate film, a polypropylene film, a polyethylene film, a polycarbonate film, a polyethylene naphthalate film, a polyallylate film, a nylon film, a polytetrafluoroethylene film, and the like can be given.

Although there are no specific limitations to the thickness of the metal foil and the resin supporting film, the thickness is usually 1 to 150 µm, preferably 2 to 100 µm, and more preferably 3 to 75 µm, from the viewpoint of workability and the like.

If a fiber material is used as the supporting body, a prepreg in which the fiber material is impregnated with the crosslinkable resin can be obtained.
As the fiber material, any known fiber materials, including organic and/or inorganic fibers, can be used without specific limitations. As specific examples of the fiber material, glass fiber, carbon fiber, aramid fiber, polyethylene terephthalate fiber, vinylon fiber, polyester fiber, amide fiber, metal fiber, ceramic fiber, and the like can be given. These fiber materials may be used either individually or in combination of two or more. As the form of the fiber materials, a mat, cloth, nonwoven fabric, and the like can be given.

Since the polymerizable composition (A) has a low viscosity as compared with a common resin varnish and has excellent properties of impregnating the fiber material, the resulting prepreg contains the crosslinkable resin homogeneously impregnated in the fiber material. Since the prepreg can be obtained by bulk polymerization of the impregnated polymerizable composition (A) by heating to a specific temperature, a step of removing a solvent after impregnating the resin vanish as in a general method is not required. The prepreg thus has excellent productivity and is free from the problem of odor or blistering due to the remaining solvent and the like. In addition, since the crosslinkable resin formed product produced by the process of the present invention has excellent storage stability, the prepreg obtained therefrom also has excellent storage stability.

There are no specific limitations to the method of coating or impregnating the supporting body with the polymerizable composition (A). Known coating methods such as a spray-coating method, a dip-coating method, a roll-coating method, a curtain coating method, a die coating method, a slit coating method, and an atomizing method using ultrasonic waves can be used. These methods can produce smooth films with a precise thickness. Of these, the die-coating method is preferable due to excellent capability of controlling the amount coated to a supporting body, and, hence, excellent capability of precisely controlling the thickness.
The polymerizable composition (A) may be applied either to one side or to both sides of the supporting body.

Any known devices which can coat the supporting body with the polymerizable composition (A) can be used without any specific limitations. As specific example, coating devices such as an ultrasonic atomizer and a die coater can be given.

When a fiber material is used as the supporting body, the supporting body can be impregnated with the polymerizable composition (A) by the above method of applying a reasonable amount of the polymerizable composition (A) to the fiber material, layering a protective film over the fiber material, as required, and pressing the layered materials with a roller or the like.

There are no specific limitations to the amount of the polymerizable composition (A) with which the supporting body is coated. Such an amount can be appropriately determined according to the thickness of the target resin film.

When a fiber material is used as the supporting body, the impregnated material may be placed on another supporting body before heating, or the fiber material may be previously placed in a mold, then impregnated with the polymerizable composition (A), which is then polymerized by bulk polymerization according to the later-described method (b).

Although there are no specific limitations to the method for heating the supporting body coated or impregnated with the polymerizable composition (A), a method using a heating roller, a heating plate, or a heating furnace is preferable. The method using these heating instruments contributes to efficient and continuous production of cycloolefin resin films with excellent smoothness and a precise thickness by bulk polymerization of the polymerizable composition (A).

The method using a heating roller specifically comprises layering a protective film over the surface of the supporting body coated or impregnated with the polymerizable composition (A), as required, and heat-pressing the layered material using a heating roller. Heat-press using a heating roller causes bulk polymerization of the polymerizable composition (A) to produce a cycloolefin resin.

As the protective film, a film having releasability from the cycloolefin resin may be used without specific limitations. For example, a polyethylene terephthalate film, a polypropylene film, a polyethylene film, a polycarbonate film, a polyethylene naphthalate film, a polyallylate film, a nylon film, a polytetrafluoroethylene film, and the like can be given.

The method using a heating plate specifically comprises placing the supporting body coated or impregnated with the polymerizable composition (A) on a heating plate, after superposing a protective film, as required, and heating the entire material on the plate to obtain a cycloolefin resin by bulk polymerization of the polymerizable composition (A). As examples of the protective film, the same films mentioned above as the film used in the method using a heating roll can be given.

The method using a heating furnace specifically comprises placing the supporting body coated or impregnated with the polymerizable composition (A) in a furnace after superposing a protective film, as required, and heating the entire material in the furnace to obtain a cycloolefin resin by bulk polymerization of the polymerizable composition (A). As examples of the furnace, a hot blast heater in which materials are heated with a hot blast, an infrared radiation heater using an infrared radiation, and the like can be given. Of these, a hot blast heater is preferable due to easy control over the internal temperature. As examples of the protective film, the same films mentioned above as the film used in the method using a heating roll can be given.

The film-like crosslinkable resin formed product obtained in the manner mentioned above has a thickness usually of 1 mm or less, preferably 0.5 mm or less, and more preferably 0.2 mm or less.

A crosslinkable resin formed product with a desired shape can be obtained if the method (b) of using a mold for the polymerization is used. The shape may be a sheet (film), a plate, a column, a cylinder, a polygonal column, or the like.

There are no specific limitations to the shape, material, size, and the like of the mold. For example, a split-type mold having a core mold and a cavity mold may be used. The core mold and the cavity mold are fabricated so as to form a vacancy conforming to the shape of the target formed product. The polymerizable composition (A) is filled in the vacant space (cavity) and polymerized by bulk polymerization.

In the present invention, it is also possible to provide a plate-like mold such as a glass plate or a metal plate and a spacer with a specific thickness, sandwich the spacer between a pair of plate-like molds, and fill the space with the polymerizable composition (A) to obtain a sheet-like (film-like) crosslinkable resin formed product.

The filling pressure (injection pressure) applied when the polymerizable composition (A) is charged into the cavity of the mold is usually 0.01 to 10 MPa, and preferably 0.02 to 5 MPa. If the filling pressure is too low, the transcription surface formed on the internal surface of the cavity may not be satisfactorily transferred. If the filling pressure is too high, it is not economical because the mold must have high rigidity. The clamping pressure is usually in a range of 0.01 to 10 MPa.

In either the method (a) or the method (b), the polymerization temperature (peak temperature) is usually 50°C or more, preferably 80 to 200°C, and more preferably 100 to 150°C. The polymerization time may be appropriately determined in a range usually from 10 seconds to 20 minutes, and preferably not more than 5 minutes.

The polymerization reaction starts when the polymerizable composition (A) is heated to a specific temperature. The polymerization reaction is an exothermic reaction. Once the bulk polymerization is started, the temperature of the polymerizable composition rapidly increases and reaches the peak temperature in a short time (around 10 seconds to 5 minutes, for example). If the peak temperature during the polymerization reaction is too high, a crosslinkable resin may not be obtained because not only the polymerization reaction, but also the crosslinking reaction proceed.

The peak temperature during the bulk polymerization is preferably equal to or less than the one-minute half-life temperature of the crosslinking agent used. The term "one-minute half-life temperature" is a temperature at which a half amount of the crosslinking agent is decomposed in one minute. For example, the one minute half-life temperature of di-t-butylperoxide is 186°C and that of 2,5-dimethyl-2,5-bis(t-butylperoxy)-3-hexine is 194°C.

In order to prevent overheating by the heat of polymerization reaction, a reaction retardant may be added to the polymerizable composition (A), whereby the reaction can be retarded.

As examples of the reaction retardant, linear 1,5-diene compounds such as 1,5-hexadiene, 2,5-dimethyl-1,5-hexadiene, (cis, cis)-2,6-octadiene, (cis, trans)-2,6-octadiene, and (trans, trans)-2,6-octadiene; linear 1,3,5- triene compounds such as (trans)-1,3,5-hexatriene, (cis)-1,3,5-hexatriene, (trans)-2,5-dimethyl-1,3,5-hexatriene, and (cis)-2,5-dimethyl-1,3,5-hexatriene; phosphines such as triphenylphosphine, tri-n-butylphosphine, and methyldiphenylphosphine; and Lewis bases such as aniline can be given.

Among the above-mentioned cycloolefin monomers, cycloolefins having a 1,5-diene structure and a 1,3,5-triene structure in the molecule also function as a reaction retardant. Specific examples include monocyclic compounds such as 1,5-cyclooctadiene, 1,5-dimethyl-1,5-cyclooctadiene, 1,3,5-cycloheptatriene, (cis, trans, trans)-1,5,9-cyclododecatriene, 4-vinylcyclohexene, and dipentene; polycyclic compounds such as 5-vinyl-2-norbornene, 5-iso-propenyl-2-norbornene, and 5-(1-propenyl)-2-norbornene; and the like.

The amount of the reaction retardant to be added is usually 0.001 to 5 wt%, and preferably 0.002 to 2 wt% of the above-mentioned monomer liquid composition. If the amount of the reaction retardant is less than 0.001 wt%, the reaction retarding effect is not exhibited. If the amount is more than 5 wt%, on the other hand, the product properties may be impaired due to the reaction retardant which remains in the polymer. There is also a possibility that the polymerization reaction may not sufficiently proceed.

When a ruthenium complex compound having a hetero atom-containing carbene compound as a ligand is used as the metathesis polymerization catalyst, it is preferable to polymerize the polymerizable composition (A) by bulk polymerization by heating to 100°C or more at a rate of temperature increase of 20°C/min or more, and preferably 50°C/min or more.

This ruthenium complex compound has high catalytic activity in the metathesis polymerization reaction and exhibits significant temperature dependency. Therefore, if the bulk polymerization is carried out by heating the polymerizable composition (A) to 100°C or more at a high rate of temperature increase, a high polymerization reaction ratio can be achieved in a very short time.

A crosslinkable resin film with a long supporting body can be continuously produced in the above method (a) by using a long supporting body. The resulting crosslinkable resin film with a long supporting body may be rolled up, and the rolls can be stored and carried.

Specifically, the crosslinkable resin formed product can be manufactured at high productivity by a continuous process comprising a step (I) of preparing a polymerizable composition containing a cycloolefin monomer, a metathesis polymerization catalyst, a chain transfer agent, and a crosslinking agent, a step (II) of coating or impregnating the supporting body with the polymerizable composition, and a step (III) of polymerizing the polymerizable composition by ring-opening metathesis bulk polymerization by heating the polymerizable composition to a specific temperature.

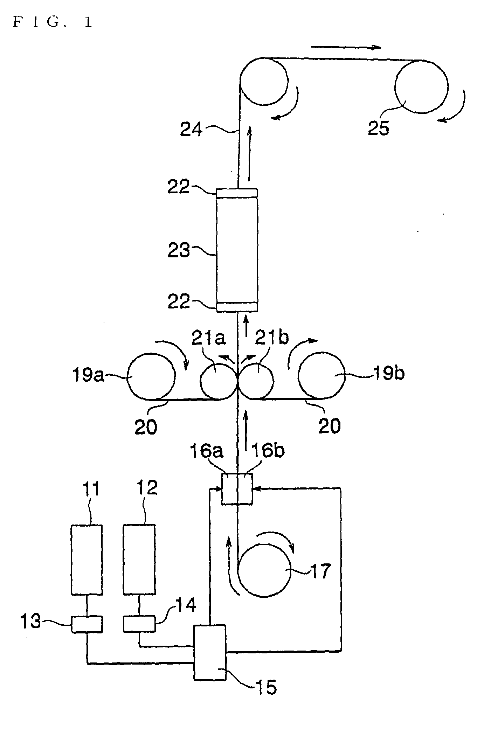

This method may be carried out using a continuous forming apparatus as shown in FIG. 1, for example.
In the continuous forming apparatus shown in FIG. 1, (11) indicates a monomer liquid composition tank which stores the monomer liquid composition containing a cycloolefin monomer, and (12) is a catalyst solution tank which stores a catalyst solution containing a metathesis polymerization catalyst. Each tank is previously cooled so that the temperature of the polymerizable composition (A) before heating is -10°C to +20°C.

Small tube pumps (13) and (14) are connected respectively to the monomer tank (11) and the catalyst tank (12) to feed the monomer liquid composition and the catalyst solution to a small static mixer (15) at a specific flow rate, wherein the monomer liquid composition and the catalyst solution are mixed to produce the polymerizable composition (A). The polymerizable composition (A) is fed to coating sections (16a) and (16b).

Meanwhile, a long supporting body (18) is forwarded from a supporting body delivery section (17) at a specific rate to continuously coat the both surfaces of the supporting body with the polymerizable composition (A) using the coating apparatus of the coating sections (16a) and (16b).

Next, long protective films (20) are sent out from the protective film delivery sections (19a) and (19b) to superpose the long protective films (20) on the coated surfaces (both sides) of the supporting body. The superposed material is caused to pass through a space with a specific gap between a pair of metal rolls (21a) and (21b) to produce a coated film with a specific coating thickness.

The product is then continuously forwarded to a hot blast heater (23) of which the inside is uniformly maintained at a specific temperature by air curtains (22) provided in the inlet port and the outlet port. The polymerizable composition (A) is heated to a specific temperature and polymerized by bulk polymerization in the hot blast heater (23) to obtain a crosslinkable resin sheet (24) with a double-sided protective film.
The crosslinkable resin sheet (24) with the protective films obtained in this manner may be rolled up by a film roll-up section (25), and the rolls may be stored and carried.

As a method for heating the supporting body coated or impregnated with the polymerizable composition (A), a method of heating the polymerizable composition (A) at a peak temperature of 50°C or more, preferably 80 to 200°C, and more preferably 100 to 150°C in a hot blast heater in which the difference of the maximum and minimum temperatures are within 10°C is preferred in the present invention.
The method contributes to a smooth chain transfer reaction in the ring-opening metathesis bulk polymerization and produces a cycloolefin resin with a smaller molecular weight distribution.

Although not particularly limited, a method of partitioning the inlet port and the outlet port of the hot blast heater with an air curtain can be given as a method for maintaining the difference of the maximum and minimum temperatures in the hot blast heater within 10°C, when a long supporting body coated or impregnated with the polymerizable composition (A) is heated while being forwarded in a specific direction at a constant speed.

Since the bulk polymerization has almost been completed in the resin, the resulting crosslinkable resin formed product contains only a very small amount of remaining monomers. The high polymerization reaction ratio results in a resin without odor due to remaining monomers, thus contributing to a good working environment. In addition, since the bulk polymerization (metathesis ring-opening polymerization) does not continue during storage, the product has excellent storage stability.

The polymerization reaction ratio of the cycloolefin resin contained in the crosslinkable resin formed product produced by the process of the present invention is usually 80% or more, preferably 90% or more, and more preferably 95% or more.
The polymerization reaction ratio of the cycloolefin resin can be determined by dissolving the resin in toluene and analyzing the resulting solution using a known analytical means such as gas chromatography, for example.

The cycloolefin resin obtained by bulk polymerization in this manner can be confirmed to be a non-crosslinked thermoplastic resin, if the resin is dissolved in an organic solvent, for example, an aromatic hydrocarbon such as benzene or toluene, an ether such as diethyl ether or tetrahydrofuran, or a halogenated hydrocarbon such as dichloromethane or chloroform.

A crosslinkable resin formed product containing a cycloolefin resin and a crosslinking agent can be obtained by the process of the present invention. Since the crosslinkable resin formed product produced by the process of the present invention has excellent flowability, a crosslinked resin formed product firmly bonded to a substrate and exhibiting excellent adhesion can be obtained by laminating the crosslinkable resin formed product and the substrate and melting and crosslinking by heating.

Although the weight average molecular weight (Mw) of the cycloolefin resin contained in the crosslinked resin formed product obtained by the process of the present invention is not particularly limited, the Mw determined by gel permeation chromatography (polystyrene reduced molecular weight) is usually from 10,000 to 50,000, preferably from 15,000 to 30,000, more preferably from 15,000 to 25,000, still more preferably from 17,000 to 25,000, and particularly preferably from 18,000 to 22,000.

The weight average molecular weight within the above range contributes to that the crosslinkable resin formed product which contains the cycloolefin resin has an excellent balance between the flowability when melted by heat and the strength of the crosslinked resin formed product obtained by crosslinking the crosslinkable resin formed product. According to the present invention, a crosslinkable resin formed product containing the cycloolefin resin with a weight average molecular weight in this range can be efficiently produced.

Although not particularly limited, the molecular weight distribution (Mw/Mn) of the cycloolefin resin is usually 4.4 or less, preferably 4.0 or less, more preferably 3.5 or less, still more preferably 3.1 or less, and particularly preferably 2.3 or less. The crosslinkable resin formed product which contains the cycloolefin resin having a molecular weight distribution within the above range has excellent flowability when melted by heat. According to the present invention, a crosslinkable resin formed product containing the cycloolefin resin with a molecular weight distribution in this range can be efficiently produced.

The shape of the crosslinkable resin formed product produced by the process of the present invention is not particularly limited. The shape may be a sheet (film), a column, a cylinder, a polygonal column, or the like.
When the crosslinkable resin formed product produced by the process of the present invention is used for a prepreg or a circuit board, a product having a shape of a sheet (film) or a product in which a fiber material is impregnated with the resin is preferable, and a product having a shape of a sheet (film) with a thickness of 0.2 mm or less is particularly preferable.

A crosslinked resin formed product may be obtained by crosslinking the crosslinkable resin formed product produced by the process of the present invention. Specifically, the crosslinked resin formed product can be obtained by heating the crosslinkable resin formed product produced by the process of the present invention to a molten state and causing the crosslinking reaction to proceed by continued heating.

The temperature for crosslinking the crosslinkable resin formed product is usually 150 to 250°C, preferably 170 to 250°C, and more preferably 180 to 220°C. In addition, a temperature above the ten minutes half-life temperature of the radical crosslinking agent is preferred. The term "ten minute half-life temperature" refers to a temperature at which a half amount of the radical crosslinking agent is decomposed in ten minutes. For example, the ten minutes half-life temperature of di-t-butylperoxide is 162°C and that of 2,5-dimethyl-2,5-bis(t-butylperoxy)-3-hexine is 170°C. Although there are no specific limitations, the time for heat-fusion and crosslinking is usually from several minutes to several hours.

The method of heat-fusion and crosslinking of the crosslinkable resin formed product is not particularly limited.
When the crosslinkable resin formed product is a film, a method of layering the film with a substrate, as required, and heat-pressing the laminate is preferably used. The pressure applied when heat-pressing is usually 0.5 to 20 MPa, preferably 1 to 10 MPa, more preferably 2 to 10 MPa, and particularly preferably 3 to 10 MPa. Heat pressing is carried out using, for example, a known press machine having a press frame pattern for flat plate molding, a press-molding machine for a sheet mold compound (SMC), a bulk mold compound (BMC), or the like. These methods are preferable due to high productivity.

When a supporting resin film is used as the supporting body, the crosslinkable resin film may be laminated with a substrate after separating from the supporting resin film. As the substrate used, metal foils, conductive polymer films, other thermoplastic resin films, and the like can be given.

When a metal foil, a metal clad laminate for outer layers, or a metal clad laminate for inner layers is used as the substrates, these substrates may be layered with the thermoplastic resin film between stainless plates and the layered materials may be press-heated to crosslink the thermoplastic resin portion to obtain a crosslinked resin-metal clad laminate or a wiring board.

When a metal foil is used as the supporting body, a crosslinked resin-metal clad laminate can be obtained by crosslinking the thermoplastic resin portion of the resulting resin-attached metal foil.

Moreover, a multilayer printed wiring board can be obtained by laminating the film-like crosslinkable resin formed product produced by the process of the present invention and a printed circuit board, and crosslinking the cycloolefin resin portion.

A commonly used printed circuit board for inner layers may be used as the printed circuit board without any specific limitations. According to the present invention, the cycloolefin crosslinked resin having excellent electric insulation properties and mechanical strength can finely adhere to the printed circuit board for inner layers and can efficiently provide a firmly bonded multilayer printed wiring board.

### EXAMPLES

The present invention is described below in more detail by way of examples and comparative examples. Note that the present invention is not limited to the following examples. In the examples and comparative examples, "part(s)" means "part(s) by weight" and "%" means "wt%" unless otherwise indicated.

The number average molecular weight (Mn), weight average molecular weight (Mw), and molecular weight distribution (Mw/Mn) were determined as polystyrene-reduced values by gel permeation chromatography using tetrahydrofuran (THF) as an eluent.

### (Example 1)

A monomer liquid composition was prepared by mixing 40 parts of 1,4-methano-1,4,4a,9a-tetrahydrofluorene as an aromatic ring-containing cycloolefin, 15 parts of 2-norbornene and 45 parts of tetracyclododecene as other cycloolefins, 2.74 parts of allyl methacrylate as a chain transfer agent, and 1.14 parts of di-t-butyl peroxide (one minute half-life temperature: 186°C) as a crosslinking agent.

Separately from the monomer liquid composition, a catalyst solution was prepared by dissolving 51 parts of benzylidene(1,3-dimesitylimidazolidin-2-ylidene) (tricyclohexylphosphine)ruthenium dichloride and 79 parts of tributylphosphine in 952 parts of tetrahydrofuran.

A monomer liquid composition tank (11) and a catalyst solution tank (12) of the continuous forming apparatus shown in FIG. 1 were charged respectively with the monomer liquid composition and the catalyst solution, and each tank was cooled to 10°C. Small tube pumps (13) and (14) were connected respectively to the monomer liquid composition tank (11) and the catalyst solution tank (12) to feed the solutions to a small static mixer (15) (a spiral type mixer having 24 elements with an element length of 3.18 mm) at a flow rate respectively of 15 ml/min and 0.12 ml/min to obtain a mixed solution (polymerizable composition) at a temperature of 10°C. The mixed composition was sent to coating sections (16a) and (16b).

A band of glass cloth (18) (2112/630/AS 891AW: manufactured by Asahi Schwebel Co., Ltd.) with a thickness of 75 µm and a width of 630 mm was forwarded from a supporting body delivery section (17) at a delivery rate of 50 mm/second to the coating sections (16a) and (16b), where the glass cloth was continuously coated and impregnated with the above polymerizable composition to a coated film's thickness of 110 µm using a two-sided die coater.

Next, two bands of polyethylene naphthalate film (20) (Q51: manufactured by Teijin-du Pont Film Co.) with a thickness of 25 µm and a width of 500 mm were sent out from the protective film delivery sections (19a) and (19b) to superpose the protective films (20) on both of the coated sides of the glass cloth. The superposed material was caused to pass through a space with a gap of 150 µm between a pair of metal rolls (21a) and (21 b) to produce a coated film with a thickness of 100 µm.

The product was continuously conveyed to a hot blast heater (23) with a length of 3000 mm of which the inside was uniformly maintained at 150 ± 5°C by air curtains (22) provided in the inlet port and the outlet port. The polymerizable composition was heated to 150°C in 20 seconds and polymerized by bulk polymerization in the hot blast heater (23) to obtain a resin sheet (24) with protective films. The resulting resin sheet was rolled up together with the protective films around a film roll-up section (25). The weight average molecular weight of the resin sheet (24) was 20,000, and the molecular weight distribution was 3.1.

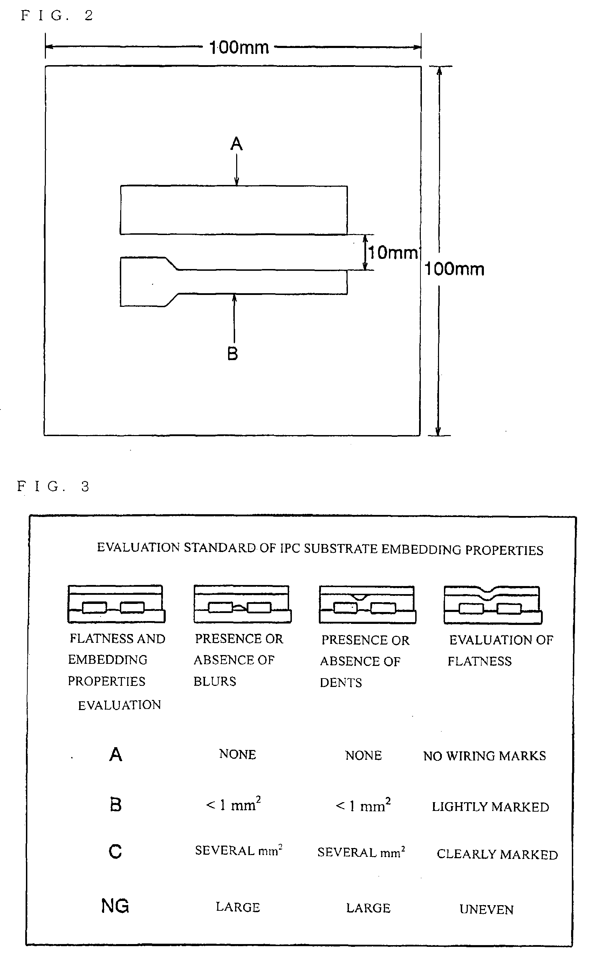

After removing the protective films, the resulting resin sheet (24) was cut into a 100 mm × 100 mm square. An electrolytic copper foil (F00-WS: manufactured by Furukawa Circuit Foil Co., Ltd.) with a thickness of 12 µm was attached to one side, followed by application of a resist. The resist was exposed to radiation through a pattern paper of an IPC multipurpose substrate shown in FIG. 2, followed by etching to remove the copper foil outside the developed area using an etchant.

The resin sheet (24) was further superposed on the top and heat-pressed to obtain a sample 1 with a thickness of 200 µm. The heat pressing conditions were set at a pressure of 3 MPa and a temperature of 200°C for 15 minutes.

### (Examples 2 to 4)

Resin sheets and samples 2 to 4 of Examples 2 to 4 were obtained in the same manner as in Example 1, except for setting the temperature of the tank of the continuous forming apparatus shown in FIG. 1 (temperature of the polymerizable composition before heating) at 10°C and changing the bulk polymerization temperature of 150°C to the temperatures shown in Table 1.

(Examples 5 and 6) Resin sheets and samples 5 and 6 were obtained in the same manner as in Example 1, except for using 1.70 parts of hexenyl methacrylate (Example 5) or 3.00 parts of undecenyl methacrylate (Example 6) instead of 2.74 parts of allyl methacrylate as a chain transfer agent.

### (Comparative Examples 1 and 2)

Resin sheets and samples 7 and 8 of Comparative Examples 1 and 2 were obtained in the same manner as in Example 1, except for setting the temperature of the tank of the continuous forming apparatus shown in FIG. 1 (temperature of the polymerizable composition before heating) at 10°C and changing the bulk polymerization temperature of 150°C to the temperatures shown in Table 1.

The chain transfer agents, the temperatures of the polymerizable composition before heating, the polymerization temperatures, the weight average molecular weights, and the molecular weight distributions of the resulting cycloolefin resins in Examples 1-6 and Comparative Examples 1,2 are shown in Table 1.

The flatness and embedding properties of the resulting samples were evaluated.
The flatness and embedding properties were evaluated by cutting the samples in the direction of the line A-B shown in FIG. 2 and inspecting the cut section by naked eye.
In the evaluation of the flatness and embedding properties, the samples were inspected for three items of the presence or absence of blurs, the presence or absence of dents, and flatness. The results were shown by A, B, C, and NG according to the following standards.

### (Presence or absence of blurs)

A: There are no blurs.
B: There are blurs with a size less than 1 mm square.
C: There are blurs with a size of 1 to 3 mm square.
NG: There are blurs with a size larger than 3 mm square.

### (Presence or absence of dents)

A: There are no dents.
B: There are dents with a size less than 1mm square.
C: There are dents with a size of 1 to 3 mm square.
NG: There are dents with a size larger than 3 mm square.

### (Evaluation of flatness)

A: There are no remaining wiring marks.
B: There are wiring marks remaining slightly.
C: There are distinct wiring marks remaining.
NG: There is unevenness on the surface.
The evaluation results are shown in Table 1. In the column of "IPC substrate evaluation" in Table 1, the results obtained by comprehensively judging the item with the worst evaluation among the presence or absence of blurs, the presence or absence of dents, and flatness are shown.

**TABLE 1**

| | Example | | | | | | Comparative Example | |
|---|---|---|---|---|---|---|---|---|
| | 1 | 2 | 3 | 4 | 5 | 6 | 1 | 2 |
| Chain transfer agent | Allyl methacrylate | Allyl methacrylate | Allyl methacrylate | Allyl methacrylate | Hexenyl methacrylate | Undecenyl methacrylate | Allyl methacrylate | Allyl methacrylate |
| Temperature of polymerizable composition before heating (°C) | 10 | 18 | 10 | 18 | 10 | 10 | 25 | 25 |
| Polymerization temperature (°C) | 150 | 150 | 130 | 130 | 150 | 150 | 130 | 145 |
| Weight average molecular weight (×10⁴) | 2.0 | 2.2 | 2.3 | 2.5 | 2.2 | 2.2 | 2.6 | 3.1 |
| Molecular weight distribution | 3.1 | 3.8 | 3.9 | 4.3 | 1.9 | 2.4 | 4.6 | 4.9 |
| IPC substrate evaluation | A | B | B | C | A | A | NG | NG |

It can be seen from Table 1 that cycloolefin resins with a narrow molecular weight distribution in a range of 1.9 to 4.3 can be obtained by maintaining the temperature of the polymerizable composition before heating was maintained in the range of -10°C to +20°C in Examples 1 to 6. On the other hand, the cycloolefin resins produced by maintaining the temperature of the polymerizable composition before heating at 25°C in Comparative Examples 1 and 2 were confirmed to have a broad molecular weight distribution of 4.6 to 4.9.
Based on the results of flatness and embedding property evaluation using an IPC substrate, it was confirmed that the narrower molecular weight distribution, the more excellent flatness and embedding properties. Particularly, the crosslinkable resin formed products with a molecular weight distribution of 3.5 or less were confirmed to have excellent flatness and embedding properties (Examples 1, 5, and 6).

## Claims

1. A process for producing a crosslinkable resin formed product comprising the steps of : providing a polymerizable composition comprising a cycloolefin monomer, a metathesis polymerization catalyst, a chain transfer agent, and a crosslinking agent, and heating the polymerizable composition to 50°C or more to effect ring-opening metathesis bulk polymerization, the temperature of the polymerizable composition before heating being maintained at -10°C to +20°C.

2. The process according to claim 1, wherein the polymerizable composition is heated to 80 to 200°C when polymerized by ring-opening metathesis bulk polymerization.

3. The process according to claim 1 or 2, wherein the heating is carried out by using a heating roller, a heating plate, or a heating furnace.

4. The process according to claim 1 or 2, wherein the heating is carried out by using a hot blast heater in which the difference between the maximum temperature and the minimum temperature is not more than 10°C.

5. A process for producing a crosslinkable resin formed product comprising a step (I) of preparing a polymerizable composition by mixing a cycloolefin monomer, a metathesis polymerization catalyst, a chain transfer agent, and a crosslinking agent, a step (II) of coating or impregnating a supporting body with the polymerizable composition, and a step (III) of effecting ring-opening metathesis bulk polymerization by heating the polymerizable composition to 50°C or more, the polymerizable composition before heating being maintained at -10°C to +20°C.

6. The process according to claim 5, wherein the supporting body is a long supporting body, and the steps (I) to (III) are continuously carried out while the supporting body is forwarded in a specific direction.

7. The process according to claim 5 or 6, wherein the supporting body is a resin film, a fiber material, or a metal foil.

8. The process according to any one of claims 5 to 7, wherein the step (III) is carried out by using a hot blast heater in which the difference of the maximum temperature and the minimum temperature is not more than 10°C.

9. The process according to any one of claims 1 to 8, wherein the cycloolefin monomer has an aromatic ring.

10. The process according to any one of claims 1 to 9, wherein the metathesis polymerization catalyst is a ruthenium complex catalyst having a hetero atom-containing carbene compound as a ligand.
